(19) **Europäisches Patentamt European Patent Office Office européen des brevets**

(11) **EP 4 766 109 A1**

(12) **EUROPEAN PATENT APPLICATION**
published in accordance with Art. 153(4) EPC

(43) Date of publication:
24.06.2026 Bulletin 2026/26

(51) International Patent Classification (IPC):
*H10K 30/15* (2023.01) *H10F 71/00* (2025.01)

(21) Application number: 24853242.6

(22) Date of filing: 22.04.2024

(52) Cooperative Patent Classification (CPC):
H10K 30/15; H10K 30/50; H10K 71/00;
Y02E 10/549

(86) International application number:
PCT/CN2024/089100

(87) International publication number:
WO 2025/035826 (20.02.2025 Gazette 2025/08)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 17.08.2023 CN 202311038872

(71) Applicant: Contemporary Amperex Technology
Co., Limited
Ningde, Fujian 352100 (CN)

(72) Inventors:
• MA, Junfu
Ningde, Fujian 352100 (CN)

• CHEN, Changsong
Ningde, Fujian 352100 (CN)
• XIANG, Ling
Ningde, Fujian 352100 (CN)
• GUO, Wenming
Ningde, Fujian 352100 (CN)
• GUO, Yongsheng
Ningde, Fujian 352100 (CN)

(74) Representative: Ziebig Hengelhaupt Intellectual
Property Attorneys
Patentanwaltskanzlei PartGmbB
Leipziger Straße 49
10117 Berlin (DE)

(54) **SOLAR CELL AND PREPARATION METHOD THEREFOR, AND PHOTOVOLTAIC ASSEMBLY, SYSTEM AND ELECTRIC APPARATUS**

(57) The present application relates to a solar cell and a preparation method therefor, and a photovoltaic assembly, a system and an electric apparatus. The solar cell comprises a first electrode layer, a first hole transport layer, a perovskite light absorption layer and a second electrode layer, which are arranged in a stacked manner, wherein components of the first hole transport layer comprise P-type tin oxide. The solar cell has a relatively high photoelectric conversion efficiency.

FIG. 1

EP 4 766 109 A1

**Description**

RELATED APPLICATION

The present application claims priority to Chinese Patent Application No. 2023110388722, filed with the China National Intellectual Property Administration on August 17, 2023 and entitled "SOLAR CELL AND PREPARATION METHOD THEREFOR, PHOTOVOLTAIC MODULE AND SYSTEM, AND ELECTRIC DEVICE", the content of which is incorporated herein by reference in its entirety.

TECHNICAL FIELD

The present application relates to the field of material technologies, and in particular, to a solar cell and a preparation method therefor, a photovoltaic module and system, and an electric device.

BACKGROUND

Perovskite materials are organic-inorganic metal halides $ABX_3$, which have an octahedral structure, are abundant in raw material reserves, and can be widely synthesized by artificial methods. The perovskite materials have various advantages such as a high photoelectric absorption coefficient, a long carrier diffusion length, a shallow defect level, and the like, such that the perovskite material has a small photoelectric loss. A solar cell using a perovskite material as a light absorption layer has the advantages of cost reduction and efficiency enhancement, a high weak-light effect, and wide application scenarios, and is an excellent choice for a new generation of mass-produced photovoltaic cells.
However, the photoelectric conversion efficiency of perovskite solar cells needs to be improved.

SUMMARY

Based on this, the present application is intended to provide a solar cell capable of improving the photoelectric conversion efficiency and a preparation method therefor, a photovoltaic module and system, and an electric device.
A first aspect of the present application provides a solar cell. The solar cell includes a first electrode layer, a first hole transport layer, a perovskite light absorption layer, and a second electrode layer that are disposed in a stacked manner, where a component of the first hole transport layer includes a P-type tin oxide.
Without wishing to be limited to any theory, in the above solar cell, the first hole transport layer containing the P-type tin oxide is disposed between the perovskite light absorption layer and the first electrode layer, which is beneficial to improving the stability of the perovskite light absorption layer and meanwhile, ensures good hole transport performance, thereby improving the photoelectric conversion efficiency of the solar cell device.
In any embodiment of the present application, the P-type tin oxide has a chemical formula of SnOx, where $1 \leq x < 2$.
In any embodiment of the present application, $1 \leq x \leq 1.8$.
In any embodiment of the present application, $1.2 \leq x \leq 1.8$.
In any embodiment of the present application, $1.5 \leq x \leq 1.8$.
In any embodiment of the present application, the component of the first hole transport layer further includes a non-tin metal inorganic compound.
In any embodiment of the present application, the non-tin metal inorganic compound includes at least one of $Al_2O_3$, $MoO_3$, $Cu_2O$, CuI, CuSCN, and CuO.
In any embodiment of the present application, the first hole transport layer includes a mixed layer formed by the non-tin metal inorganic compound and the P-type tin oxide.
In any embodiment of the present application, in the mixed layer, a mass fraction of the P-type tin oxide is $> 0$ and $\leq 50\%$.
In any embodiment of the present application, in the mixed layer, the mass fraction of the P-type tin oxide is 5% to 50%.
In any embodiment of the present application, in the mixed layer, the mass fraction of the P-type tin oxide is 20% to 50%.
In any embodiment of the present application, the first hole transport layer includes a P-type tin oxide layer and an intermediate layer. The intermediate layer includes the non-tin metal inorganic compound, and the P-type tin oxide layer is located between the intermediate layer and the perovskite light absorption layer.
In any embodiment of the present application, a thickness proportion of the P-type tin oxide layer in a total thickness of the first hole transport layer is $> 0$ and $\leq 50\%$.
In any embodiment of the present application, the thickness proportion of the P-type tin oxide layer in the total thickness of the first hole transport layer is 5% to 50%.

In any embodiment of the present application, the thickness proportion of the P-type tin oxide layer in the total thickness of the first hole transport layer is 20% to 50%.

In any embodiment of the present application, the solar cell further includes a second hole transport layer. The second hole transport layer is disposed between the first electrode layer and the first hole transport layer, and materials of the second hole transport layer and the first hole transport layer are different.

In any embodiment of the present application, the solar cell satisfies at least one of the following conditions:

(1) the second hole transport layer includes at least one of PTAA, a nickel oxide, Spiro-OMeTAD, $WO_3$, PEDOT:PSS, poly(3-hexylthiophene), a triphenylamine compound, and a carbazole compound;

(2) a thickness ratio of the second hole transport layer to the first hole transport layer is (0.8 to 10):1; and

(3) the first electrode layer is a transparent electrode layer.

In any embodiment of the present application, the solar cell satisfies at least one of the following conditions: the solar cell satisfies at least one of the following conditions:

(1) the second hole transport layer includes at least one of PTAA and a nickel oxide;

(2) the thickness ratio of the second hole transport layer to the first hole transport layer is (2 to 10):1;

(3) a thickness of the first hole transport layer does not exceed 20 nm; and

(4) a thickness of the second hole transport layer is 15 nm to 30 nm.

In any embodiment of the present application, the solar cell satisfies at least one of the following conditions: the solar cell satisfies at least one of the following conditions:

(1) the thickness ratio of the second hole transport layer to the first hole transport layer is (2 to 6):1; and

(2) the thickness of the first hole transport layer is 5 nm to 10 nm.

A second aspect of the present application provides a preparation method for the solar cell of the first aspect of the present application. The preparation method includes the following step:
forming the first electrode layer, the first hole transport layer, the perovskite light absorption layer, and the second electrode layer that are disposed in a stacked manner.

In any embodiment of the present application, the preparation method further includes a step of forming the second hole transport layer between the first electrode layer and the first hole transport layer.

A third aspect of the present application provides a photovoltaic module. The photovoltaic module includes the solar cell provided in the first aspect of the present application.

A fourth aspect of the present application provides a photovoltaic system. The photovoltaic system includes the photovoltaic module provided in the third aspect of the present application.

A fifth aspect of the present application provides an electric device. The electric device includes at least one selected from the solar cell provided in the first aspect of the present application and the photovoltaic module provided in the third aspect of the present application.

The details of one or more embodiments of the present application are set forth in the drawings and description below. Other features, objectives, and advantages of the present application become apparent from the specification, the drawings, and the claims.

BRIEF DESCRIPTION OF THE DRAWINGS

To more clearly illustrate the technical solutions in embodiments of the present application or in conventional techniques, the drawings required for illustrating the embodiments or description of the conventional techniques are briefly described below. Apparently, the drawings in the following description illustrate merely the embodiments of the present application, and those of ordinary skill in the art may still derive other drawings from the disclosed drawings without creative efforts.

FIG. 1 is a schematic diagram of a solar cell according to an embodiment of the present application;

FIG. 2 is a schematic diagram of a solar cell according to another embodiment of the present application; and

FIG. 3 is a schematic diagram of an electric device using a solar cell as a power source according to an embodiment of the present application.

Description of the reference numerals:

1. solar cell; 11. transparent electrode; 12. second hole transport layer; 13. first hole transport layer; 14. perovskite light absorption layer; 15. electron transport layer; 16. counter electrode layer; 2. electric device.

DETAILED DESCRIPTION

The technical solutions in embodiments of the present application will be clearly and completely described hereinafter with reference to the drawings in the embodiments of the present application. It is apparent that the described embodiments are only some, but not all, embodiments of the present application. Based on the embodiments in the present application, all other embodiments obtained by those of ordinary skill in the art without creative efforts shall fall within the protection scope of the present application.

Hereinafter, the embodiments of the present application are specifically disclosed in detail with appropriate reference to the drawings. However, unnecessarily detailed descriptions may be omitted. For example, detailed descriptions of well-known matters and repetitive descriptions of actually identical structures may be omitted. This is to avoid unnecessary lengthiness of the following descriptions and to facilitate understanding by those skilled in the art. Additionally, the drawings and the following descriptions are provided to enable those skilled in the art to fully understand the present application and are not intended to limit the subject matter recited in the claims.

The "ranges" disclosed in the present application are defined by lower and upper limits. A given range is defined by selecting a lower limit and an upper limit that delineate the boundaries of a particular range. Ranges defined in this manner may include or exclude the end values and can be combined arbitrarily, which means that any lower limit may be combined with any upper limit to form a range. For example, if ranges of 60 to 120 and 80 to 110 are listed for a particular parameter, it will be appreciated that ranges of 60 to 110 and 80 to 120 are also anticipated. Additionally, if the minimum range values listed are 1 and 2, and the maximum range values listed are 3, 4, and 5, then the following ranges can all be anticipated: 1 to 3, 1 to 4, 1 to 5, 2 to 3, 2 to 4, and 2 to 5. In the present application, unless otherwise specified, the numerical range "a to b" represents an abbreviated representation of any combination of real numbers between a and b, where both a and b are real numbers. For example, the numerical range "0 to 5" indicates that all real numbers between 0 and 5 are listed herein, and "0 to 5" is merely an abbreviated representation of a combination of these numerical values. Additionally, when stating that a parameter is an integer $\geq 2$, it is equivalent to disclosing that the parameter is, for example, an integer of 2, 3, 4, 5, 6, 7, 8, 9, 10, 11, 12, or the like.

Unless otherwise specified, all embodiments and optional embodiments of the present application can be combined with one another to form new technical solutions. Unless otherwise specified, all technical features and optional technical features of the present application can be combined with one another to form new technical solutions.

Unless otherwise specified, all steps of the present application can be performed sequentially or randomly, preferably sequentially. For example, if the method includes steps (a) and (b), it indicates that the method may include steps (a) and (b) performed sequentially or steps (b) and (a) performed sequentially. For example, if the mentioned method may further include step (c), it indicates that step (c) may be added to the method in any order; for example, the method may include steps (a), (b) and (c), or steps (a), (c) and (b), or steps (c), (a) and (b), or the like.

Unless otherwise specified, the "include" and "comprise" mentioned in the present application are open-ended. For example, the "include" and "comprise" may mean that other unlisted components may also be included or comprised or that only the listed components are included or comprised.

Unless otherwise specified, the term "or" in the present application is inclusive. For example, the phrase "A or B" means "A, B, or both A and B". More specifically, any one of the following conditions satisfies the condition "A or B": A is true (or present) and B is false (or absent); A is false (or absent) and B is true (or present); or both A and B are true (or present).

An embodiment of the present application provides a solar cell. The solar cell includes a first electrode layer, a first hole transport layer, a perovskite light absorption layer, and a second electrode layer that are disposed in a stacked manner. The component of the first hole transport layer includes a P-type tin oxide.

Without wishing to be limited to any theory, in the above solar cell, the first hole transport layer containing the P-type tin oxide is disposed between the perovskite light absorption layer and the first electrode layer, which is beneficial to improving the stability of the perovskite light absorption layer and ensures good hole transport performance, thereby improving the photoelectric conversion efficiency of the solar cell device.

In addition, in the conventional techniques, the acidic PEDOT:PSS is used as the first hole transport layer, which accelerates the degradation of a perovskite material when it is in contact with the perovskite material, which is not beneficial to improving the stability of the solar cell device and thus improving the photoelectric conversion efficiency thereof; meanwhile, PEDOT:PSS is an organic hole transport material, which is often prepared by a spin coating process, which is not beneficial to the industrial production of large-area perovskite modules. Compared with PEDOT:PSS, the first hole transport layer of the above solar cell contains the P-type tin oxide, which is not only beneficial to improving the stability of the solar cell device and thus improving the photoelectric conversion efficiency thereof, but also can adopt processes such as physical vapor deposition, chemical vapor deposition, and the like, which is beneficial to industrial production.

In some embodiments, the thickness of the perovskite light absorption layer is 200 nm (nanometers) to 1000 nm. As an example, the thickness of the perovskite light absorption layer is 200 nm, 300 nm, 400 nm, 500 nm, 600 nm, 700 nm, 800 nm, 900 nm, or 1000 nm, optionally 400 nm to 500 nm.

The perovskite light absorption layer can be prepared by a preparation method commonly used in the art, including but not limited to a sol-gel method, coating, multi-source co-evaporation, and other methods. It can be understood that the coating includes, but is not limited to, spin coating, slit coating, brush coating, wipe coating, blade coating, screen coating, spray coating, and the like. Further, the perovskite light absorption layer is a three-dimensional perovskite thin film.

In some embodiments, the above perovskite light absorption layer includes a perovskite material. The general formula of the perovskite material is $ABX_3$ or $A_2CDX_6$; the A ion is a monovalent cation, the B ion is a divalent metal cation, the C ion is a monovalent metal cation, the D ion is a trivalent metal cation, and the X ion is a monovalent anion.

Optionally, the A ion includes at least one of an organic cation and a metal cation. More optionally, the organic cation includes at least one of an organic amine ion, a formamidino (FA) group, and an imidazolyl group; more optionally, the metal cation includes at least one of $Li^+$, $Na^+$, $K^+$, $Rb^+$, and $Cs^+$. Further, the organic amine ion includes at least one of a methylamine (MA) group, an ethylamine group, a propylamine group, a butylamine group, a pentylamine group, and a hexylamine group.

Optionally, the B ion includes at least one of $Pb^{2+}$, $Sn^{2+}$, $Be^{2+}$, $Mg^{2+}$, $Ca^{2+}$, $Sr^{2+}$, $Ba^{2+}$, $Zn^{2+}$, $Ge^{2+}$, $Fe^{2+}$, $Co^{2+}$, $Cu^{2+}$, and $Ni^{2+}$; more optionally, the B ion includes one or both of $Pb^{2+}$ and $Sn^{2+}$,

Optionally, the C ion includes at least one of $Cs^+$, $Ag^+$, $K^+$, and $Ru^+$.

Optionally, the D ion includes at least one of $Bi^{3+}$, $Ni^{3+}$, $Fe^{3+}$, and $Cu^{3+}$.

Optionally, the X ion includes at least one of $F^-$, $Cl^-$, $Br^-$, and $I^-$; optionally, the X ion includes at least one of $Cl^-$, $Br^-$, and $I^-$.

It can be understood that the perovskite material in the above perovskite light absorption layer may be selected from at least one of $CsFAPbX_3$, $CsMAPbX_3$, $CsFAMAPbX_3$, $CsPbX_3$, $MAPbX_3$, $FAPbX_3$, $CsFAPbSnX_3$, $CsMAPbSnX_3$, $CsFAMAPbSnX_3$, $CsPbSnX_3$, $MAPbSnX_3$, and $FAPbSnX_3$. Further, as an example, the perovskite material in the above perovskite light absorption layer may be selected from at least one of $CsFAPbI_3$, $CsPbI_3$, and $FAPbI_3$.

As an example, the general formula of the perovskite material is as follows: $Cs_aFA_bMA_cPb_dSn_eI_fBr_g$, where a = 0 to 0.05, b = 0.8 to 0.95, c = 0 to 0.1, d = 0.5 to 1, e = 0 to 0.5, f = 2.0 to 3, g = 0 to 1, a + b + c = 1, d + e = 1, and f + g = 3.

In some embodiments, the P-type tin oxide has a chemical formula of $SnOx$, where $1 \leq x < 2$. The tin oxide of this chemical formula has an oxygen vacancy, and therefore good hole transport performance is ensured.

As an example, the x may be 1, 1.1, 1.2, 1.3, 1.4, 1.5, 1.6, 1.7, 1.8, or 1.9. Optionally, $1 \leq x \leq 1.8$; more optionally, $1.2 \leq x \leq 1.8$. Further optionally, $1.5 \leq x \leq 1.8$.

It can be understood that, in some embodiments, the component of the first hole transport layer is a P-type tin oxide, and no other hole transport materials are added.

In some other embodiments, the component of the first hole transport layer further includes a non-tin metal inorganic compound. It can be understood that the "non-tin metal inorganic compound" refers to an inorganic compound formed by a metal other than tin. Further, the non-tin metal inorganic compound includes at least one of $Al_2O_3$, $MoO_3$, $Cu_2O$, CuI, CuSCN, and CuO. In other words, the hole transport material of the first hole transport layer includes not only the P-type tin oxide, but also the non-tin metal inorganic compound, such as at least one of $Al_2O_3$, $MoO_3$, $Cu_2O$, CuI, CuSCN, and CuO.

Further, in an example, the first hole transport layer includes a mixed layer formed by the non-tin metal inorganic compound and the P-type tin oxide, for example, a mixed layer formed by a P-type tin oxide and at least one of $Al_2O_3$, $MoO_3$, $Cu_2O$, CuI, CuSCN, and CuO. In this way, by regulating the components and the ratio of the mixed layer, energy levels of the first hole transport layer and other functional layers are more matched, such that the performance of the solar cell device is better.

Further, in the mixed layer, a mass fraction of the P-type tin oxide is > 0 and ≤ 50%, optionally 5% to 50% or 20% to 50%. As an example, in the mixed layer, the mass fraction of the P-type tin oxide may be 5%, 10%, 15%, 20%, 25%, 30%, 35%, 40%, 45%, or 50%.

It can be understood that the mixed layer may be prepared by adding a plurality of raw materials. For example, when an atomic layer deposition method is used, two deposition raw materials may be used.

Further, in another example, the first hole transport layer includes a P-type tin oxide layer and an intermediate layer. The intermediate layer includes a non-tin metal inorganic compound, such as at least one of $Al_2O_3$, $MoO_3$, $Cu_2O$, CuI, CuSCN, and CuO, and the P-type tin oxide layer is located between the intermediate layer and the perovskite light absorption layer. The P-type tin oxide layer includes a P-type tin oxide, or the material of the P-type tin oxide is the P-type tin oxide.

As an example, the first hole transport layer includes a P-type tin oxide layer and an intermediate layer that are disposed in a stacked manner. The intermediate layer may be an aluminum oxide layer, a molybdenum oxide layer, or a cuprous oxide layer, or a layer formed by at least two of an aluminum oxide, a molybdenum oxide, and a cuprous oxide.

Further, a thickness proportion of the P-type tin oxide layer in the total thickness of the first hole transport layer is > 0 and ≤ 50%, optionally 5% to 50% or 20% to 50%. As an example, the thickness proportion of the P-type tin oxide layer in the total thickness of the first hole transport layer may be 5%, 10%, 15%, 20%, 25%, 30%, 35%, 40%, 45%, or 50%.

It can be understood that stacked layers of the P-type tin oxide layer and the intermediate layer may be prepared in two steps, and the preparation method for each layer may be specifically selected. It can be understood that, in some combination schemes, the first hole transport layer may include both the above mixed layer and the stacked layers of the above P-type tin oxide layer and the intermediate layer, and the relative positions of the three stacked layers are not limited; optionally, the P-type tin oxide layer is in direct contact with the perovskite light absorption layer.

Further, the preparation method for the above first hole transport layer may be a process such as physical vapor deposition (PVD), chemical vapor deposition (CVD), atomic layer deposition (ALD), or spin coating, preferably ALD.

In some embodiments, the above solar cell further includes a second hole transport layer. The second hole transport layer is disposed between the first electrode layer and the first hole transport layer. The materials of the second hole transport layer and the first hole transport layer are different. The first hole transport layer made of a different material is disposed between the second hole transport layer and the perovskite light absorption layer, and the component of the first hole transport layer includes a P-type tin oxide, thus forming a structure of a double-layer hole transport layer, which, compared with a conventional single-layer hole transport layer, can improve hole transport performance of the solar cell, thereby improving the photoelectric conversion efficiency of the solar cell device.

In some embodiments, the material of the second hole transport layer includes, but is not limited to, at least one of the following materials and derivatives thereof: poly[bis(4-phenyl)(2,4,6-trimethylphenyl)amine] (PTAA), NiOx (nickel oxide), 2,2',7,7'-tetrakis[N,N-di(4-methoxyphenyl)amino]-9,9'-spirobifluorene (Spiro-OMeTAD), $WO_3$, poly(3,4-ethylenedioxythiophene):poly(styrenesulfonate) (PEDOT:PSS), poly(3-hexylthiophene) (P3HT), a triphenylamine compound, a carbazole compound, and other materials that can transport holes and block electrons.

The triphenylamine compound includes, but is not limited to, triphenylamine with triptycene as a core (H101) and 3,4-ethylenedioxythiophene-methoxytriphenylamine (EDOT-OMeTPA). The carbazole compound includes, but is not limited to, N-(4-aniline)carbazole-spirobifluorene (CzPAF-SBF) and a phosphate carbazole compound. Further, the second hole transport layer includes at least one of PTAA and a nickel oxide (NiOx) compound.

The most widely used hole transport materials in current inverted perovskite solar cells include NiOx and PTAA.

In the case that NiOx is in direct contact with the perovskite light absorption layer, $Ni^{3+}$ in the NiOx undergoes a redox reaction with organic cations of the perovskite material in the perovskite light absorption layer, resulting in degradation of the perovskite material and severely limiting the service life thereof. Therefore, in the case that the material of the second hole transport layer is NiOx, the first hole transport layer containing the P-type tin oxide is disposed between the second hole transport layer and the perovskite light absorption layer, such that the redox reaction between $Ni^{3+}$ and the organic cations in the perovskite material can be inhibited, thereby inhibiting the degradation of the perovskite material, which is beneficial to improving the stability of the perovskite light absorption layer and the solar cell device, and prolonging the service life of the solar cell device.

The strong hydrophobicity of PTAA results in extremely poor wettability of a perovskite precursor solution on its surface, which affects the crystallization of the perovskite material and is not beneficial to the manufacturing of high-performance solar cell devices. Therefore, in the case that the material of the second hole transport layer is PTAA, the first hole transport layer containing the P-type tin oxide is disposed between the second hole transport layer and the perovskite light absorption layer, such that the wettability between PTAA and the perovskite precursor solution in the preparation process can be improved, which is beneficial to improving the crystallization quality of the prepared perovskite material and promoting the industrial production of solar cell devices.

In some embodiments, a thickness ratio of the second hole transport layer to the first hole transport layer is (0.8 to 10):1. As an example, the thickness ratio may be 0.8:1, 1:1, 2:1, 2.5:1, 3:1, 4:1, 5:1, 6:1, 7:1, 8:1, 9:1, or 10:1. The thickness ratio of the second hole transport layer to the first hole transport layer may be (2 to 10):1, more optionally (2 to 6):1.

In some embodiments, the thickness of the first hole transport layer does not exceed 10 nm, and is optionally 5 nm to 10 nm. As an example, the thickness of the first hole transport layer may be 2 nm, 3 m, 5 nm, 7 nm, 8 nm, 9 nm, or 10 nm.

In some embodiments, the thickness of the second hole transport layer is 15 nm to 30 nm. As an example, the thickness of the second hole transport layer may be 15 nm, 20 nm, 25 nm, or 30 nm.

Optionally, the above solar cell may be further provided with an electron blocking layer between the first electrode layer and the second hole transport layer. The material of the electron blocking layer may be a known material.

In some embodiments, the solar cell may further include an electron transport layer between the perovskite light absorption layer and the second electrode layer.

As an example, the material of the electron transport layer may be, but is not limited to, at least one of the following materials and derivatives thereof: an imide compound, a quinone compound, a fullerene and a derivative thereof, methoxytriphenylamine-fluoroformamidine (OMeTPA-FA), [6,6]-phenyl C61 methyl butyrate (PCBM), [6,6]-phenyl C71 methyl butyrate (PC71BM), calcium titanate ($CaTiO_3$), lithium fluoride (LiF), calcium fluoride ($CaF_2$), poly(3,4-ethylene-dioxythiophene):poly(styrenesulfonate) (PEDOT:PSS), poly(3-hexylthiophene) (P3HT), triphenylamine with triptyene as a core (H101), 3,4-ethylenedioxythiophene-methoxytriphenylamine (EDOT-OMeTPA), N-(4-aniline)carbazole-spirobifluorene (CzPAF-SBF), polythiophene, a metal oxide (the metal element is selected from Mg, Ni, Cd, Zn, In, Pb, Mo, W, Sb, Bi, Cu, Hg, Ti, Ag, Mn, Fe, V, Sn, Zr, Sr, Ga, or Cr), a silicon oxide ($SiO_2$), strontium titanate ($SrTiO_3$), and cuprous thiocyanate (CuSCN).

Optionally, the above solar cell may be further provided with a hole blocking layer between the second electrode layer and the electron transport layer.

The material of the hole blocking layer may include, but is not limited to, BCP (2,9-dimethyl-4,7-diphenyl-1,10-phenanthroline).

In a specific example, the electron transport layer is a PCBM layer, and the hole blocking layer is a BCP layer. The BCP layer is used as a passivation layer of the electron transport layer, and the BCP molecular structure contains N atoms with lone pair electrons, which can effectively passivate surface defects of the PCBM layer, promote the transport and separation of charges at the interface, and is beneficial to eliminating current hysteresis of cell devices.

It can be understood that, in order to enable light to be effectively transmitted to the perovskite light absorption layer, at least one electrode in the solar cell is provided as a transparent electrode, and the other electrode is a counter electrode layer.

It can be understood that the solar cell includes a regular structure and an inverted structure in terms of structure. Optionally, one of the first electrode layer and the second electrode layer is a transparent electrode, and the other may be a counter electrode layer.

The transparent electrode may be a transparent conductive metal oxide electrode. As an example, the material of the transparent electrode may be, for example, a transparent conductive glass such as FTO, ITO, AZO, BZO, IZO, and the like. It can be understood that the transparent electrode may employ a transparent flexible substrate in addition to a glass substrate. Specifically, the material of the transparent flexible substrate may be, for example, an organic polymer material, and may be a mixture of one or more of the following materials in different proportions: polyvinyl alcohol (PVA), polyester (PET), polyimide (PI), polyethylene naphthalate (PEN), and polydimethylsiloxane (PDMS).

The material of the counter electrode layer includes, but is not limited to, an organic material, an inorganic material, or a conductive material in which the organic material and the inorganic material are mixed in different proportions. Further, the counter electrode layer is a metal electrode. The metal conductive material of the counter electrode layer includes, but is not limited to, gold (Au), silver (Ag), copper (Cu), aluminum (Al), nickel (Ni), chromium (Cr), bismuth (Bi), platinum (Pt), magnesium (Mg), or a mixture thereof.

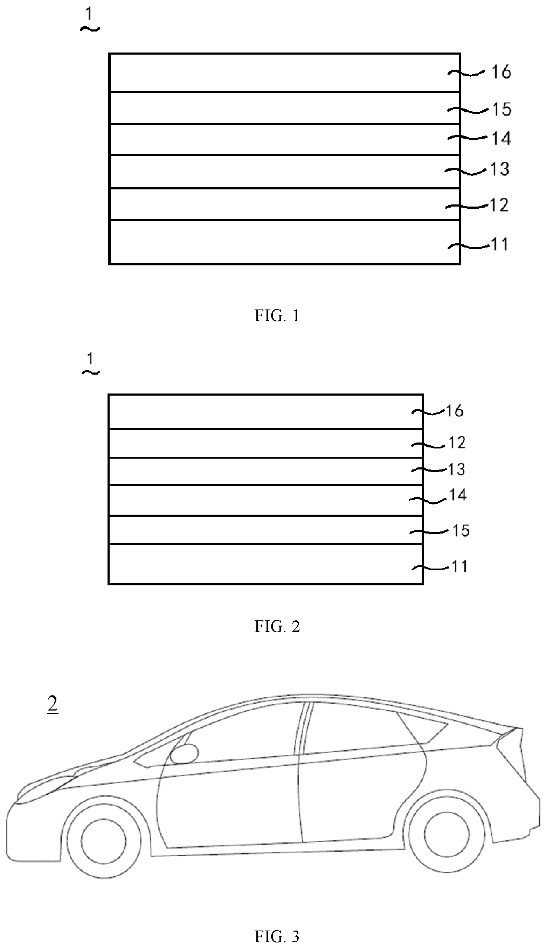

For the inverted structure, as an example, as shown in FIG. 1, the solar cell includes a transparent electrode 11, and a second hole transport layer 12, a first hole transport layer 13, a perovskite light absorption layer 14, an electron transport layer 15, and a counter electrode layer 16 that are sequentially stacked on the transparent electrode 11. The above first electrode layer is the transparent electrode 11, and the second electrode layer is the counter electrode layer 16.

For the regular structure, as an example, as shown in FIG. 2, the solar cell includes a transparent electrode 11, and an electron transport layer 15, a perovskite light absorption layer 14, a first hole transport layer 13, a second hole transport layer 12, and a counter electrode layer 16 that are sequentially stacked on the transparent electrode 11. The above first electrode layer is the counter electrode layer, and the second electrode layer is the transparent electrode.

The present application further provides a preparation method for the above solar cell. The preparation method includes forming a first electrode layer, a second hole transport layer, a first hole transport layer, a perovskite light absorption layer, and a second electrode layer that are disposed in a stacked manner.

In some embodiments, the above preparation method includes the following steps S11 to S14:

S11, forming the second hole transport layer on the first electrode layer;

S12, forming the first hole transport layer on the surface of the second hole transport layer distal to the first electrode layer;

S13, forming the perovskite light absorption layer on the surface of the first hole transport layer distal to the second hole transport layer; and

S14, forming the first electrode layer on the surface of the perovskite light absorption layer distal to the first hole transport layer.

Specifically, as an example, the solar cell is an inverted type, and the preparation method therefor includes the following steps:

step 1: etching, cleaning, and drying a transparent electrode;

step 2: sequentially preparing the second hole transport layer and the first hole transport layer on the transparent electrode;

step 3: preparing the perovskite light absorption layer on the first hole transport layer;

step 4: preparing an electron transport layer on the perovskite light absorption layer; and

step 5: preparing a counter electrode layer on the electron transport layer.

It can be understood that, when the solar cell is a regular type, the preparation sequence is slightly different, and can be slightly adjusted according to the structure of the solar cell.

In some examples, the preparation method for the above perovskite light absorption layer includes the following steps: mixing a material containing A, $BX_2$, and a solvent to obtain a perovskite precursor solution; and applying the perovskite precursor solution on a corresponding substrate and performing annealing to obtain the perovskite light absorption layer.

The above first electrode, the second hole transport layer, the first hole transport layer, the electron transport layer, and the second electrode may be prepared by a preparation method commonly used in the art, including but not limited to a solution method and a solid deposition method. The solution method includes any one of a spin coating method, spray coating, a blade coating method, a slit coating method, and the like. The solid deposition method includes any one of vacuum evaporation, sputtering deposition, plasma deposition, and ion deposition.

An embodiment of the present application further provides a photovoltaic module. The photovoltaic module includes the above solar cell.

The above solar cell has high light conversion efficiency and good stability, and can improve the efficiency of the photovoltaic module.

The above photovoltaic module includes one or more of the above solar cells, and may be selected based on a specific application scenario. Further, the above photovoltaic module includes a plurality of the above solar cells, and the plurality of the above solar cells are connected in series or in parallel to form a cell sheet. Further, the above photovoltaic module may further include a stacked cell, and the stacked cell includes one or more of the above solar cells. The stacked cell includes, but is not limited to, a crystalline silicon/perovskite stacked cell, a full-perovskite stacked cell, and a copper indium gallium selenide (CIGS) thin-film cell/perovskite stacked cell.

In some embodiments, the above photovoltaic module further includes a photovoltaic glass layer, an adhesive layer, and a backplane.

Two surfaces of the cell sheet are separately provided with adhesive layers. The backplane is disposed on the surface of one of the adhesive layers distal to the cell sheet, and the photovoltaic glass layer is disposed on the surface of the other adhesive layer distal to the cell sheet.

The photovoltaic glass layer and the backplane are configured to protect the solar cell, and have functions of sealing, insulation, and waterproofing. The adhesive layer has a function of bonding the photovoltaic glass layer and the cell sheet, and bonding the backplane and the cell sheet.

Optionally, the material of the photovoltaic glass layer is tempered glass, the material of the backplane is TPT (polyvinyl fluoride) or TPE (thermoplastic elastomer), and the material of the adhesive layer is EVA (polyethylene-polyvinyl acetate copolymer).

Further, the above photovoltaic module further includes a junction box and an outer frame.

The junction box is configured to protect a power generation system of the entire photovoltaic module, and is equivalent to a current transfer station. When the cell sheet is short-circuited, the junction box automatically disconnects the short-circuited cell string.

The outer frame can support and protect the entire photovoltaic module, and the frame may be made of an aluminum alloy material, which has excellent strength and corrosion resistance.

Further, a joint between the frame and another portion of the photovoltaic module is bonded and sealed by silica gel. The photovoltaic module may convert solar energy into electric energy, or send the electric energy to a storage battery for storage, or drive a load to work.

In some embodiments, the above photovoltaic module is a solar panel.

An embodiment of the present application further provides a photovoltaic system. The photovoltaic system includes the above photovoltaic module.

The photovoltaic system directly converts solar radiation energy into electric energy by using the photovoltaic effect of the solar cell in the above photovoltaic module with high efficiency. Further, the above photovoltaic system is a photovoltaic power generation system.

The photovoltaic module is a core part of the photovoltaic power generation system. The above photovoltaic system includes one or more photovoltaic modules, and may be selected based on a specific application scenario. Further, when the above photovoltaic system includes a plurality of photovoltaic modules, the plurality of photovoltaic modules form a photovoltaic array.

The above photovoltaic system may be an independent photovoltaic power generation system, or may be a grid-tied photovoltaic power generation system.

The independent photovoltaic power generation system includes a photovoltaic array, a storage battery set, a charging controller, a power electronic converter (inverter), a load, and the like. The working principle of the independent photovoltaic power generation system is as follows: Solar radiation energy is first converted into electric energy through the photovoltaic array, and then is converted by the power electronic converter to power the load; in addition, excess electric energy is stored in an energy storage device in the form of chemical energy through the charging controller. In this way, when sunlight is insufficient, the energy stored in the battery can be converted into electric energy of alternating current 220 V and 50 Hz through the power electronic inverter, filtering, and boost by a power frequency transformer for use by an alternating current load.

The grid-tied photovoltaic power generation system includes a photovoltaic array, a high-frequency DC/DC boost converter, a power electronic converter (inverter), and a system monitor. The working principle of the grid-tied photovoltaic power generation system is as follows: Solar radiation energy is converted through the photovoltaic array, then turned into a high-voltage direct current through high-frequency direct current conversion, and then inverted by the power electronic inverter to output a sinusoidal alternating current with the same phase and frequency as a power grid, to the power grid.

The above two photovoltaic power generation systems have respective features, and may be selected based on a specific application scenario.

An embodiment of the present application provides an electric device. The electric device includes the above solar cell or the above photovoltaic module.

In some embodiments, the above solar cell or the photovoltaic module may be used as a power source of the electric device, or may be used as an energy storage unit of an electric device.

Further, the above electric device may include, but is not limited to, a mobile device, such as a mobile phone or a laptop computer, an electric vehicle, an electric train, a ship, a satellite, and the like.

FIG. 3 shows an electric device as one example. The electric device 2 is a pure electric vehicle, a hybrid electric vehicle, a plug-in hybrid electric vehicle, or the like.

In order to make the technical problems to be addressed, the technical solutions, and the beneficial effects of the present application more apparent, the present application is further described in detail below with reference to the drawings and embodiments. Apparently, the described examples are merely some examples of the present application, rather than all of the examples. The following description of at least one exemplary example is merely illustrative and is in no way intended to limit the present application and the application thereof. Based on the examples in the present application, all other examples obtained by those of ordinary skills in the art without creative work shall fall within the protection scope of the present application.

The examples without techniques or conditions specified therein are implemented according to techniques or conditions described in the literature in the art or according to product instructions. Reagents or instruments used herein without specified manufacturers are all commercially available conventional products.

I. Manufacturing of Device

Example 1

A manufacturing method for a solar cell device with an inverted structure is as follows:

1) Preparation of an FTO conductive glass electrode: 0.35 cm of FTO was removed at both ends of a FTO glass with a specification of $2.0 \times 2.0$ cm$^2$ by laser etching, and a glass substrate was exposed; and the etched FTO conductive glass was ultrasonically cleaned with water, acetone, and isopropanol in sequence for several times, and then blown dry with nitrogen for later use;

2) Preparation of a second hole transport layer: The FTO was subjected to ultraviolet-ozone treatment, then a nickel oxide with a thickness of about 20 nm was subjected to magnetron sputtering, and annealing was performed at 300 °C for 60 min to obtain the second hole transport layer;

3) Preparation of a first hole transport layer: SnOx (x = 1.76, obtained by performing an XPS test on a thin film; the value of x was controlled by controlling an oxygen supply amount in an atomic layer deposition process, the same below) with a thickness of about 5 nm was prepared on a surface of the second hole transport layer by using the atomic layer deposition method to obtain the first hole transport layer;

4) Preparation of a perovskite light-absorbing layer: The perovskite light absorption layer was prepared by a one-step method; specifically, a perovskite precursor solution was applied on the prepared first hole transport layer by spin coating at a speed of 4000 rpm for 20 to 40 s, 300 to 600 $\mu$L of an antisolvent was added dropwise at about 10 s after the spin coating started, and then the thin film was placed on a heating stage and annealed at 120 °C for 60 min to obtain a perovskite light absorption layer with a thickness of 500 nm, where the composition of a perovskite material in the perovskite light absorption layer was $Cs_{0.05}FA_{0.95}PbI_3$;

5) Preparation of an electron transport layer: The device with the perovskite light-absorbing layer prepared in step 4) was placed in an evaporator, and when the vacuum degree of evaporation was below $5 \times 10^{-4}$ Pa, an electron transport layer (C60 layer) with a thickness of 30 nm and a passivation layer (or a hole blocking layer, made of BCP) with a thickness of 5 nm disposed on the electron transport layer were sequentially evaporated at a rate of 0.05 A/s; and

6) Preparation of a metal counter electrode: The thin film with the electron transport layer prepared in step 5) was placed in the evaporator, and when the vacuum degree of evaporation was below $5 \times 10^{-4}$ Pa, a metal Cu back electrode with a thickness of 80 nm was evaporated at a rate of 0.1 A/s.

Example 2

Except for step 2), the other steps were the same as those in Example 1. Step 2) was specifically as follows.

2) Preparation of a second hole transport layer: The FTO was subjected to ultraviolet-ozone treatment, then 2 mg/mL PTAA organic hole transport layer was applied by spin coating at a rate of 5000 rpm/s, and then annealing treatment was performed on the heating stage at 100 °C for 10 minutes to obtain the second hole transport layer with a thickness of about 30 nm.

Examples 3 to 5

These examples were substantially the same as Example 1, except that x of SnOx in the first hole transport layer (SnOx layer) was controlled to be different by controlling the oxygen supply amount in the atomic layer deposition process in the first hole transport layer in step 3), as shown in Table 1.

Examples 6 to 8

These examples were substantially the same as Example 1, except that the thickness of the first hole transport layer (the SnOx layer) was controlled to be different by controlling the time in the atomic layer deposition process in the first hole transport layer in step 3), as shown in Table 1.

Example 9

This example was substantially the same as Example 1, except that the second hole transport layer was omitted, and only the first hole transport layer was included, as shown in Table 1.

Examples 10 to 15

These examples were substantially the same as Example 1, except that, on the basis that the thickness of the first hole transport layer remained unchanged, the raw materials in the atomic layer deposition process in the first hole transport layer in step 3) were controlled to be different, such that the deposited first hole transport layer was controlled to be a mixed layer; and the mass content of SnOx in the mixed layer was controlled by controlling the proportion of the raw materials, as shown in Table 2.

Examples 16 to 21

These examples were substantially the same as Example 1, except that, after the P-type SnOx layer was deposited and formed in step 3), an intermediate layer was formed on the basis of the P-type SnOx layer by continuing to use the atomic layer deposition method; and subsequently, a perovskite light-absorbing layer was formed on the intermediate layer, as shown in Table 3.

Comparative Example 1

This comparative example was substantially the same as Example 1, except that the type of the first hole transport layer deposited in step 3) was different, which was specifically as follows:
3) Preparation of a first hole transport layer: An aluminum oxide with a thickness of about 5 nm was prepared on a surface of the second hole transport layer by an atomic layer deposition method to obtain the first hole transport layer.

Comparative Example 2

This comparative example was substantially the same as Example 1, except that the type of the first hole transport layer deposited in step 3) was different, which was specifically as follows:
3) Preparation of a first hole transport layer: A cuprous oxide with a thickness of about 5 nm was prepared on a surface of the second hole transport layer by an atomic layer deposition method to obtain the first hole transport layer.

Comparative Example 3

This comparative example was substantially the same as Example 2, except that the type of the first hole transport layer deposited in step 3) was different, which was specifically as follows:
3) Preparation of a first hole transport layer: An aluminum oxide with a thickness of about 5 nm was prepared on a surface of the second hole transport layer by an atomic layer deposition method to obtain the first hole transport layer.

Comparative Example 4

This comparative example was substantially the same as Example 2, except that the type of the first hole transport layer deposited in step 3) was different, which was specifically as follows:
3) Preparation of a first hole transport layer: A molybdenum oxide with a thickness of about 5 nm was prepared on a surface of the second hole transport layer by an atomic layer deposition method to obtain the first hole transport layer.

II. Performance Test

Photoelectric conversion efficiency of perovskite solar cells

The cell performance was tested using a Keithley 2400SMU, AM 1.5G solar irradiation under a light source of 100 mW/cm$^2$, and the photoelectric conversion efficiency was calculated as follows:

$$PCE = Pout/Popt$$

$$= Voc \times Jsc \times (Vmpp \times Jmpp)/(Voc \times Jsc)$$

$$= Voc \times Jsc \times FF$$

Pout, Popt, Vmpp, Jmpp, Voc, and Jsc are respectively the operating output power of the cell, the incident optical power, the voltage at the maximum power point of the cell, the current at the maximum power point of the cell, the open-circuit voltage, and the short-circuit current.
Four perovskite solar cells obtained in each of the above examples and comparative examples were tested according to the above process, and the obtained results were averaged, with specific results shown in Tables 1 to 3.

Table 1

| Group | First hole transport layer | | Second hole transport layer | VOC(V) | FF(%) | Jsc(mA/cm$^2$) | PCE(%) |
|---|---|---|---|---|---|---|---|
| | P-type SnOx layer | Thickness | Type | | | | |
| Example 1 | x=1.76 | 5 nm | Nickel oxide | 1.09 | 81.18 | 24.59 | 21.70 |
| Example 2 | x=1.76 | 5 nm | PTAA | 1.09 | 81.63 | 24.31 | 21.56 |
| Example 3 | x=1.5 | 5 nm | Nickel oxide | 1.08 | 80.67 | 24.37 | 21.26 |
| Example 4 | x=1.2 | 5 nm | Nickel oxide | 1.10 | 78.84 | 24.75 | 21.36 |
| Example 5 | x=1 | 5 nm | Nickel oxide | 1.10 | 77.79 | 24.66 | 21.03 |
| Example 6 | x=1.76 | 10 nm | Nickel oxide | 1.07 | 79.65 | 24.82 | 21.18 |
| Example 7 | x=1.76 | 8 nm | Nickel oxide | 1.08 | 79.19 | 24.78 | 21.16 |
| Example 8 | x=1.76 | 2 nm | Nickel oxide | 1.10 | 77.29 | 24.61 | 21.00 |
| Example 9 | x=1.76 | 10 nm | / | 1.10 | 77.48 | 23.61 | 20.16 |
| Comparative Example 1 | $Al_2O_3$ | 5 nm | Nickel oxide | 1.10 | 77.13 | 23.24 | 19.79 |
| Comparative Example 2 | $Cu_2O$ | 5 nm | PTAA | 1.10 | 79.09 | 22.73 | 19.78 |
| Comparative Example 3 | $Al_2O_3$ | 5 nm | PTAA | 1.09 | 76.61 | 22.93 | 19.22 |
| Comparative Example 4 | $Mo_2O_3$ | 5 nm | PTAA | 1.08 | 75.01 | 23.58 | 19.09 |

Table 2

| Group | First hole transport layer (mixed layer) | | | VOC(V) | FF(%) | Jsc(mA/cm$^2$) | PCE(%) |
|---|---|---|---|---|---|---|---|
| | Type | Thickness | Mass content of SnOx | | | | |
| Example 1 | $SnO_{1.76}$ | 5 nm | 100% | 1.09 | 81.18 | 24.59 | 21.70 |
| Example 10 | $SnO_{1.76}+Al_2O_3$ | 5 nm | 50% | 1.10 | 81.15 | 24.64 | 22.01 |
| Example 11 | $SnO_{1.76}+Al_2O_3$ | 5 nm | 30% | 1.10 | 80.77 | 24.65 | 21.87 |
| Example 12 | $SnO_{1.76}+Al_2O_3$ | 5 nm | 20% | 1.09 | 81.19 | 24.66 | 21.79 |
| Example 13 | $SnO_{176}+Al_2O_3$ | 5 nm | 5% | 1.08 | 79.38 | 25.00 | 21.45 |
| Example 14 | $SnO_{1.76}+Mo_2O_3$ | 5 nm | 30% | 1.10 | 80.36 | 24.59 | 21.81 |
| Example 15 | $SnO_{1.76}+Cu_2O$ | 5 nm | 30% | 1.11 | 81.34 | 24.18 | 21.78 |

Table 3

| Group | First hole transport layer | | | VOC(V) | FF(%) | Jsc(mA/cm$^2$) | PCE(%) |
|---|---|---|---|---|---|---|---|
| | P-type SnOx layer | Intermediate layer | Thickness proportion of SnOx layer | | | | |
| Example 1 | $SnO_{1.76}$, 5 nm | / | 100% | 1.09 | 81.18 | 24.59 | 21.70 |
| Example 16 | $SnO_{1.76}$, 5 nm | $Al_2O_3$ | 50% | 1.13 | 79.10 | 24.71 | 22.11 |
| Example 17 | $SnO_{1.76}$, 5 nm | $Al_2O_3$ | 30% | 1.11 | 81.76 | 24.17 | 21.85 |
| Example 18 | $SnO_{1.76}$, 5 nm | $Al_2O_3$ | 20% | 1.10 | 79.77 | 24.77 | 21.74 |
| Example 19 | $SnO_{1.76}$, 5 nm | $Al_2O_3$ | 5% | 1.08 | 80.11 | 24.77 | 21.38 |
| Example 20 | $SnO_{1.76}$, 5 nm | $Mo_2O_3$ | 30% | 1.10 | 80.69 | 24.64 | 21.86 |

(continued)

| Group | First hole transport layer | | | VOC(V) | FF(%) | Jsc(mA/cm²) | PCE(%) |
|---|---|---|---|---|---|---|---|
| | P-type SnOx layer | Intermediate layer | Thickness proportion of SnOx layer | | | | |
| Example 21 | $SnO_{1.76}$, 5 nm | $Cu_2O$ | 30% | 1.10 | 80.19 | 24.75 | 21.83 |

As can be seen from Tables 1 to 3, the photoelectric conversion performance of the solar cells prepared in Examples 1 to 20 is higher than that of each comparative example.

In Table 1, the only difference between Examples 1 to 2 is that the materials of the second hole transport layer are different, and the prepared solar cells have good photoelectric conversion performance; the only difference between Examples 1 and 3 to 5 is that x of SnOx in the first hole transport layer (SnOx layer) is different, x is further 1.2 to 1.8, and the prepared solar cells have good photoelectric conversion performance. The difference between Examples 1 and 6 to 8 is only that the thickness of the first hole transport layer is different, and the thickness is further 5 nm to 10 nm, and the prepared solar cells have good photoelectric conversion performance. In Example 9, only the first hole transport layer is included, and the second hole transport layer is not included. The prepared solar cells also have good photoelectric conversion performance.

As can be seen from Table 2, the difference between Examples 10 to 15 and Example 1 is that the first hole transport layer is made of a mixed material on the basis that the thickness of the first hole transport layer remains unchanged. Compared with Example 1, the solar cells prepared in Examples 10 to 15 have better photoelectric conversion performance. Further, the solar cells prepared by controlling the mass content of SnOx in the first hole transport layer to be 20% to 50% have better photoelectric conversion performance.

As can be seen from Table 3, the difference between Examples 16 to 21 and Example 1 is that, on the basis that the thickness of the SnOx layer remains unchanged, an intermediate layer is formed on the SnOx layer by using another material, and the SnOx layer and the intermediate layer together serve as the first hole transport layer; compared with Example 1, the solar cells prepared in Examples 16 to 21 have better photoelectric conversion performance. Further, by controlling the thickness proportion of the SnOx layer in the first hole transport layer to be 20% to 50%, the prepared solar cells have better photoelectric conversion performance.

The technical features of the examples described above may be combined in any manner. For brevity, not all possible combinations of the technical features in the above examples are described. However, as long as no contradiction exists in the combinations of the technical features, such combinations should be considered to be within the scope of the specification.

The aforementioned examples merely illustrate several embodiments of the present application, which are described in a specific and detailed manner, but should not be construed as limiting the patent scope of the present application. It should be noted that various changes and modifications can be made by those skilled in the art without departing from the concept of the present application, and these changes and modifications shall all fall within the protection scope of the present application. Therefore, the scope of protection of the patent in the present application shall be subject to the appended claims.

**Claims**

1. A solar cell, comprising a first electrode layer, a first hole transport layer, a perovskite light absorption layer, and a second electrode layer that are disposed in a stacked manner, wherein a component of the first hole transport layer comprises a P-type tin oxide.

2. The solar cell according to claim 1, wherein the P-type tin oxide has a chemical formula of SnOx, wherein $1 \leq x < 2$.

3. The solar cell according to claim 2, wherein $1 \leq x \leq 1.8$.

4. The solar cell according to claim 3, wherein $1.2 \leq x \leq 1.8$.

5. The solar cell according to claim 4, wherein $1.5 \leq x \leq 1.8$.

6. The solar cell according to any one of claims 1 to 5, wherein the component of the first hole transport layer further comprises a non-tin metal inorganic compound.

7.  The solar cell according to claim 6, wherein the non-tin metal inorganic compound comprises at least one of $Al_2O_3$, $MoO_3$, $Cu_2O$, CuI, CuSCN, and CuO.

8.  The solar cell according to claim 6 or 7, wherein the first hole transport layer comprises a mixed layer formed by the non-tin metal inorganic compound and the P-type tin oxide.

9.  The solar cell according to claim 8, wherein a mass fraction of the P-type tin oxide in the mixed layer is > 0 and $\leq$ 50%.

10. The solar cell according to claim 9, wherein the mass fraction of the P-type tin oxide in the mixed layer is 5% to 50%.

11. The solar cell according to claim 10, wherein the mass fraction of the P-type tin oxide in the mixed layer is 20% to 50%.

12. The solar cell according to claim 6 or 7, wherein the first hole transport layer comprises a P-type tin oxide layer and an intermediate layer, wherein the intermediate layer comprises the non-tin metal inorganic compound, and the P-type tin oxide layer is located between the intermediate layer and the perovskite light absorption layer.

13. The solar cell according to claim 12, wherein a thickness proportion of the P-type tin oxide layer in a total thickness of the first hole transport layer is > 0 and $\leq$ 50%.

14. The solar cell according to claim 13, wherein the thickness proportion of the P-type tin oxide layer in the total thickness of the first hole transport layer is 5% to 50%.

15. The solar cell according to claim 14, wherein the thickness proportion of the P-type tin oxide layer in the total thickness of the first hole transport layer is 20% to 50%.

16. The solar cell according to any one of claims 1 to 15, wherein the solar cell further comprises a second hole transport layer, wherein the second hole transport layer is disposed between the first electrode layer and the first hole transport layer, and materials of the second hole transport layer and the first hole transport layer are different.

17. The solar cell according to claim 16, wherein the solar cell satisfies at least one of the following conditions:

    (1) the second hole transport layer comprises at least one of PTAA, a nickel oxide, Spiro-OMeTAD, $WO_3$, PEDOT:PSS, poly(3-hexylthiophene), a triphenylamine compound, and a carbazole compound;
    (2) a thickness ratio of the second hole transport layer to the first hole transport layer is (0.8 to 10):1; and
    (3) the first electrode layer is a transparent electrode layer.

18. The solar cell according to claim 17, wherein the solar cell satisfies at least one of the following conditions:

    (1) the second hole transport layer comprises at least one of PTAA and a nickel oxide;
    (2) the thickness ratio of the second hole transport layer to the first hole transport layer is (2 to 10):1;
    (3) a thickness of the first hole transport layer does not exceed 20 nm; and
    (4) a thickness of the second hole transport layer is 15 nm to 30 nm.

19. The solar cell according to claim 18, wherein the solar cell satisfies at least one of the following conditions:

    (1) the thickness ratio of the second hole transport layer to the first hole transport layer is (2 to 6):1; and
    (2) the thickness of the first hole transport layer is 5 nm to 10 nm.

20. A preparation method for the solar cell according to any one of claims 1 to 19, comprising the following step: forming the first electrode layer, the first hole transport layer, the perovskite light absorption layer, and the second electrode layer that are disposed in a stacked manner.

21. The preparation method for the solar cell according to claim 20, wherein the preparation method further comprises a step of forming a second hole transport layer between the first electrode layer and the first hole transport layer.

22. A photovoltaic module, comprising the solar cell according to any one of claims 1 to 19.

23. A photovoltaic system, comprising the photovoltaic module according to claim 22.

24. An electric device, comprising at least one selected from the solar cell according to any one of claims 1 to 19 and the photovoltaic module according to claim 22.

1

FIG. 1

1

FIG. 2

2

FIG. 3

## INTERNATIONAL SEARCH REPORT

| International application No. |
| --- |
| **PCT/CN2024/089100** |

| A. | CLASSIFICATION OF SUBJECT MATTER |
| --- | --- |

H10K 30/15(2023.01)i; H01L 31/18(2006.01)i

According to International Patent Classification (IPC) or to both national classification and IPC

| B. | FIELDS SEARCHED |
| --- | --- |

Minimum documentation searched (classification system followed by classification symbols)

IPC: H01L, H10K

Documentation searched other than minimum documentation to the extent that such documents are included in the fields searched

Electronic data base consulted during the international search (name of data base and, where practicable, search terms used)

CNTXT; ENTXT; ENTXTC; DWPI; CNKI; IEEE: 电池, 光伏, 空穴, 电子, 氧化锡, 钙钛矿, 组件, 厚度, 钝化, 修饰, cell, photovoltaic, hole, electron, tin oxide, SnO, perovskite, component, thickness, passivation, modify

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 114220925 A (DALIAN INSTITUTE OF CHEMICAL PHYSICS, CHINESE ACADEMY OF SCIENCES) 22 March 2022 (2022-03-22) description, paragraphs 67-94, and figure 2 | 1-5, 16-24 |
| A | CN 114220925 A (DALIAN INSTITUTE OF CHEMICAL PHYSICS, CHINESE ACADEMY OF SCIENCES) 22 March 2022 (2022-03-22) entire document | 6-15 |
| X | CN 115224199 A (WUXI JIDIAN LIGHT ENERGY TECHNOLOGY CO., LTD.) 21 October 2022 (2022-10-21) description, paragraphs 38-55, and figures 1-2 | 1, 20 |
| A | CN 109148688 A (FUDAN UNIVERSITY) 04 January 2019 (2019-01-04) entire document | 1-24 |
| A | CN 116096105 A (SHANGHAI JIAO TONG UNIVERSITY) 09 May 2023 (2023-05-09) entire document | 1-24 |
| A | CN 116075945 A (KABUSHIKI KAISHA TOSHIBA et al.) 05 May 2023 (2023-05-05) entire document | 1-24 |

☑ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **06 June 2024** | **13 June 2024** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

# EP 4 766 109 A1

**INTERNATIONAL SEARCH REPORT**

International application No.

**PCT/CN2024/089100**

**C.  DOCUMENTS CONSIDERED TO BE RELEVANT**

| Category* | Citation of document, with indication, where appropriate, of the relevant passages | Relevant to claim No. |
|---|---|---|
| A | KR 20160069461 A (LG CHEMICAL LTD.) 16 June 2016 (2016-06-16)<br>entire document | 1-24 |
| A | CN 115720481 A (HUBEI UNIVERSITY) 28 February 2023 (2023-02-28)<br>entire document | 1-24 |

Form PCT/ISA/210 (second sheet) (July 2022)

**INTERNATIONAL SEARCH REPORT**
Information on patent family members

International application No.

**PCT/CN2024/089100**

| Patent document cited in search report | | | Publication date (day/month/year) | Patent family member(s) | | | Publication date (day/month/year) |
|---|---|---|---|---|---|---|---|
| CN | 114220925 | A | 22 March 2022 | None | | | |
| CN | 115224199 | A | 21 October 2022 | None | | | |
| CN | 109148688 | A | 04 January 2019 | None | | | |
| CN | 116096105 | A | 09 May 2023 | None | | | |
| CN | 116075945 | A | 05 May 2023 | None | | | |
| KR | 20160069461 | A | 16 June 2016 | KR | 101740654 | B1 | 26 May 2017 |
| CN | 115720481 | A | 28 February 2023 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2023110388722